# EUROPEAN PATENT SPECIFICATION

(11) **EP 3 084 886 B1**
(45) Date of publication and mention of the grant of the patent: **11.12.2019**
(21) Application number: 13815725.0
(22) Date of filing: 19.12.2013
(51) Int. Cl.: H01R 4/02, H01R 12/58, H01R 43/02, H01R 12/52, H05K 3/34, H05K 3/36

(54) **A CONNECTION PIN, A CONVERTER ASSEMBLY AND A METHOD FOR MANUFACTURING A CONNECTION PIN**
VERBINDUNGSSTIFT, WANDLERANORDNUNG UND VERFAHREN ZUR HERSTELLUNG EINES VERBINDUNGSSTIFTES
BROCHE DE CONNEXION, ENSEMBLE CONVERTISSEUR ET PROCÉDÉ DE FABRICATION D'UNE BROCHE DE CONNEXION

(43) Date of publication of application: 26.10.2016
(73) Proprietor: Telefonaktiebolaget LM Ericsson (publ), 164 83 Stockholm (SE)
(72) Inventor: PEREZ-URIA, Igor, S-176 74 Järfälla (SE); DRUGGE, Lars, S-111 27 Stockholm (SE)
(74) Representative: Ericsson
(86) International application number: PCT/EP2013/077397
(87) International publication number: WO 2015/090410

(56) References cited:
- EP-A1- 0 088 582
- WO-A1-2012/115555
- US-A1- 2004 253 852
- US-A1- 2012 178 306
- US-B1- 6 552 277
- US-B1- 6 773 269
- US-B1- 7 083 431

## Description

### Technical field of the invention

The present disclosure relates to a connection pin, such as a connection pin suitable for mounting in a printed circuit board and in a substrate, e.g. a converter substrate. The present disclosure further relates to a converter assembly, and also to a method for manufacturing a connection pin.

### Background

Within the technical areas where printed circuit boards (PCB) and printed wiring boards (PWB) are used, there is a constant demand for higher component density, i.e. increasing the number of components while at the same time the available surface area is minimal. In the field of power modules, e.g. converters such as dc/dc converters, a major issue is how to increase the number of components per square mm combined with a demand for higher currents and a resulting need for more effective cooling.

According to prior art is known a dc/dc converter that is mounted to a printed circuit board (PCB) with solid pin terminals that extend into the converter substrate in order to provide electrical connection to circuitry on the substrate. Usually, the pin includes a flange that abuts the printed circuit board or alternatively the substrate, in order to space them apart. The pins are mounted in the converter substrate and the converter substrate is then mounted on the PCB by inserting the pin ends into through holes in the PCB. The pins are then soldered to the PCB. This soldering requires that solder paste is somehow added where the pins are located. One way of adding solder paste is to screen print solder around the pin holes in the PCB. The assembly comprising the substrate mounted to the PCB is then passed through a reflow oven and the solder wicks down into the hole and up the side of the flange of the pin that is in contact with the solder screen print. The screen printed solder has the drawback of taking up additional space on the PCB that could otherwise be used for circuitry and components. The solder screen print for the pins may be printed together with the solder screen print for the PCB's other surface mounted (SMT) components. However, since the required amount of solder paste for each pin sometimes is more than required for the SMT components, there is a need to dispense additional solder paste on the PCB. One way of adding more solder is to "overprint" solder on top of solder screen print that surrounds the conductor pad around the pin hole. The additional solder paste will then melt and be drawn into the desired solder joint region during the reflow process. Alternatively, additional solder paste may be dispensed through a needle, manually or by some automatic process. According to another alternative, a solder preform may be used, in the form of a thin sheet of solidified solder with the desired thickness and shape. The preform is applied around the holes of the PCB either manually or by an automatic process. The preform will take up space around the hole and reduce the space available for circuitry and components. Also other alternatives exist that involves applying solder paste to the flange of the pin, which flange is designed to be in contact with the PCB. In US 6545890 is found descriptions of the above alternatives.

From WO2012115555 is known a stackable connection pin that is provided with an internal cavity having an open end. A connection part of another connection pin can be inserted into this internal cavity. Solder paste is then added into said cavity and a melting operation is performed whereby the two connection pins are soldered together.

All of the proposed alternatives for adding additional solder paste have the drawback of requiring additional steps in the manufacturing process. Furthermore, it is important that a correct amount of solder paste is added. There must be a sufficient amount of solder paste applied to secure the pin in the hole and provide good electric and thermal contact. On the other hand, if too much solder paste is added, it may overflow onto the PCB during the reflow process and cause solder bridging that will jeopardize the product functionality. Thus this is a complicated and sensitive part of the manufacturing process that involves risks of low yield and high costs if not adjusted successfully.

Further, the addition of more solder that is required for soldering of the pins, has in most cases the disadvantage of reducing the surface space that is available for circuitry and components on the PCB, and thus reduce component density.

In other disclosures solid solder is used. In EP0088582 is disclosed a press-fit electrical terminal in which a solder slug is placed in a portion of each opposed face of a central web part of the terminal. The connection pin is then press-fitted into a recess of e.g. a PCB such that the central web part is in contact with the PCB. The solder is then melted and electrical connection with the PCB is achieved. In US 2004/0253852 is disclosed a connector having a housing with a number of terminals. Each terminal includes a tail portion to which a solder mass is attached by being inserted into an opening at the open end of the tail portion. The tail portion and the solder mass is placed onto contact pads of a PCB, and a reflow process is used to melt the solder and provide contact between the terminal and the contact pads on the PCB.

### Summary of the invention

An object of the present disclosure is to offer a connection pin that makes it possible to eliminate the extra step of adding additional solder during the process of mounting the connection pin in a PCB, and that also creates possibilities for a more reliable production process with less defective products. An additional object is to provide a connection pin that offers the possibility of higher component density on a PCB.

According to a first aspect is defined a connection pin comprising a first contact part that is adapted for mounting in a hole in a printed circuit board, PCB, by soldering to an inner wall of the hole in the printed circuit board, and a second contact part, wherein the first contact part comprises a cavity surrounded by a wall, wherein the wall has at least one opening, and wherein at least one solder preform is located in the cavity. The connection pin has an open end located at the end of the connection pin that is closest to the first part, and wherein an opening provided by the open end communicates with the cavity. This offers the advantage that the solder preform can be very conveniently introduced into the cavity via said open end.

This connection pin provides the advantages of already containing all the required solder inside the cavity of the pin and consequently no additional solder has to be added after mounting of such a pin in e.g. a PCB. This means that, when the connection pin is mounted in a PCB, no surface space on the PCB needs to be reserved for solder that is required for soldering the pin to the PCB. Further, there is no need for any additional steps of screen printing or dispensing solder in a separate step or adding preforms on top of the PCB. The manufacturing process is simplified, and the risk for the development of solder bridges is reduced. The production yield is improved since there will be less defective products. Furthermore, the PCB can then be more tightly populated by circuits and components and the advantage of a higher component density is obtained, with lower costs as one result.

The connection pin can be either a pin providing only mechanical connection between the pin and the PCB, or it can be a connection pin that also provides electrical connection between the pin and the PCB. The second contact part of the connection pin can have any configuration that is suitable for mounting in e.g. another PCB. It may be designed as a mechanical contact part or as an electric contact part, it may be configured for a press fit, slip fit with soldering or any known configuration. It is also conceivable that the second contact part has the same configuration as the first contact part.

Further, the cavity of the connection pin may contain a comparatively large amount of solder, which provides a good mechanical connection. Also the conductive interconnection between the surface of the PCB, the connection pin and inner conductive layers of the PCB, such as embedded windings or power distribution copper planes, will be improved, by e.g. improved wetting and large contact areas. In addition, not only the electrical conductivity is improved, but also the thermal conductivity is improved and as a result higher currents may be used. In order to ensure that the solder will flow out of the cavity, the surface of the cavity may be treated with a suitable substance that has a lower wetting compared to the inner wall of the hole.

According to one embodiment of the connection pin, the at least one solder preform may comprise a rod of solder. According to another embodiment of the connection pin, the at least one solder preform may comprise one or several balls of solder. According to yet another embodiment of the connection pin, the at least one solder preform may comprise at least one plate of solder. The invention offers high flexibility as to the shape and size of the solder preform, and thereby it is possible to obtain optimal interface contact between the connection pin and the PCB. If for example the solder preform is shaped as a ball, the user may choose how much solder to use by selecting one or several balls of solder to insert in the connection pin cavity.

The invention also offers different possibilities concerning how to mount the connection pin in the PCB hole. According to one embodiment, the first contact part may have an outer diameter that is adapted for a slip fit into a hole of a PCB. A slip fit is made possible by the possibility to use larger amounts of solder that is offered by the present invention and which provides improved metallic and wetting contact between the interface surfaces. When a connection pin is press fitted into the hole in the PCB, which is common in prior art, it puts high demands on the tolerances of the pin and the hole. There is a risk for extreme relative positions where the pin barely touches the wall of the hole, resulting in a risk for insufficient contact, or where the edges of the pin cut into the lining in the hole and risk damaging the lining. As a consequence, this latter risk put high demands on the copper in the hole and the need for annular rings in the PCB. A slip fit provides the advantage that there is no deformation of the sidewalls of the hole in the PCB, and less demand on tolerances.

According to another embodiment, at least a part of the wall of the cavity may be resilient, and this part of the wall may have an outer diameter that it larger than a diameter of a hole in a PCB in which the connection pin is intended to be mounted. This resilient wall part will provide a spring effect and when the connection pin is inserted into the hole, good contact is provided when the resilient part of the wall is compressed against the inner wall of the hole.

According to another alternative embodiment, the first contact part may have an outer diameter that is adapted for a press-fit into a hole in a PCB.

According to a further embodiment, the cavity may have a length corresponding to at least the length of the hole. Further, the at least one opening in the wall may have a length corresponding to the length of the hole. It will be advantageous to be able to let the solder come into contact with the inner wall of the hole, along the entire length thereof. It is also conceivable that the cavity actually has a length that exceeds the length of the hole and extends further up into the connection pin, beyond the first contact part. In this way, even more solder can be contained in the cavity.

The connection pin may further comprise an intermediate part between the first contact part and the second contact part. This intermediate part will serve to keep a distance between the PCB in which the first contact part is mounted, and another element in which the second contact part is mounted. The connection pin may comprise a flange part between the intermediate part and the second contact part. Such a flange part will serve as support or abutment for an element in which the connection pin is mounted.

According to another aspect of the invention is defined a converter assembly comprising:
- a first printed circuit board, PCB, said first PCB having at least one hole configured to receive a connection pin,
- at least one connection pin according to any one of the claims defining a connection pin, of which either one of the first contact part and the second contact part is mounted in said hole in the first PCB.

An advantage of the connection pin is that it can be used in combination with other elements such as a converter substrate comprising a PCB. Thus a converter assembly comprising a PCB, and at least one connection pin may be obtained. Such a PCB with connection pins may then be mounted on another PCB, and will display numerous advantages related to its mounting on such other PCB.

Accordingly, the converter assembly may comprise a second PCB having at least one hole, wherein the other contact part of the connection pin that is not mounted in the first PCB is mounted in said hole of the second PCB.

Further, the first contact part is soldered to the inner the wall of the hole in the PCB in which it is mounted, by means of melting the solder preform. Thus a converter assembly displaying the corresponding advantages as have already been described above in relation to the connection pin, can be obtained.

According to one embodiment, the first contact part may be soldered to the inner wall of the hole in the PCB, in which it is mounted, with a reflow process. This has the advantage of being a relatively simple process.

According to another embodiment, at least one hole in the PCB where the first contact part of the connection pin is mounted, may be a through hole. Alternatively, at least one hole in the PCB where the first contact part of the connection pin is mounted, may be a blind via.

According to a further embodiment, the converter assembly may comprise several connection pins mounted in a header, wherein the first PCB comprises at least as many holes as the number of connection pins mounted in the header, and wherein the first contact part or the second contact part of the respective connection pin is mounted in a respective hole configured therefor in the first PCB. The header provides for a simplified mounting method.

According to a further aspect of the present invention is defined a method for manufacturing a connection pin comprising a first contact part that is adapted for mounting in a hole in a printed circuit board by soldering to an inner wall of the hole in the printed circuit board, and a second contact part, the method comprising:
- providing a connection pin with a cavity in the first contact part of the connection pin, and providing at least one opening in a wall of the cavity,
- preparing at least one solder preform, and
- inserting at least one solder preform into said cavity,
characterized by inserting said at least one solder preform into the cavity via an open end of the connection pin, which open end is located at the end of the connection pin that is closest to the first contact part, and has an opening that communicates with the cavity.

This method displays advantages corresponding to the advantages already described in relation to the connection pin.

The method may further comprise inserting said at least one solder preform into the cavity via an open end of the connection pin, which open end communicates with the cavity.

Additionally, the method may comprise preparing a solder preform by cutting solder wire in lengths adapted to the length of the cavity, and pressing several solder wire lengths together thereby forming a solder preform. This has the advantage of being a simple method for providing solder preforms.

In the context of the present disclosure, the expression printed circuit board (PCB) should be interpreted as also including printed wiring board (PWB).

Further features and advantages of the invention will also become apparent from the following detailed description of embodiments.

### Brief description of the drawings

A detailed description of the present invention and embodiments thereof, given as examples only, will now be made with reference to the accompanying schematic drawings, in which:
Figs. 1a to 1c illustrate schematically a first embodiment of a connection pin according to the present invention;
Figs. 2a to 2c illustrate schematically a second embodiment of a connection pin according to the present invention;
Figs. 3a to 3c illustrate schematically a third embodiment of a connection pin according to the present invention;
Figs. 4a to 4c illustrate schematically a fourth embodiment of a connection pin according to the present invention;
Figs. 5a and 5b illustrate schematically a first embodiment of a dc/dc converter assembly according to the present invention;
Figs. 6a and 6b illustrate schematically a second embodiment of a dc/dc converter assembly according to the present invention;
Fig. 7a illustrates another embodiment of a converter assembly according to the present invention, and Fig. 7b illustrates schematically a header with connection pins according to an embodiment the present invention; and
Fig. 8 illustrates a block diagram of a method according to an aspect of the present invention.

In the figures, the same or corresponding elements have been given the same reference number.

### Detailed description

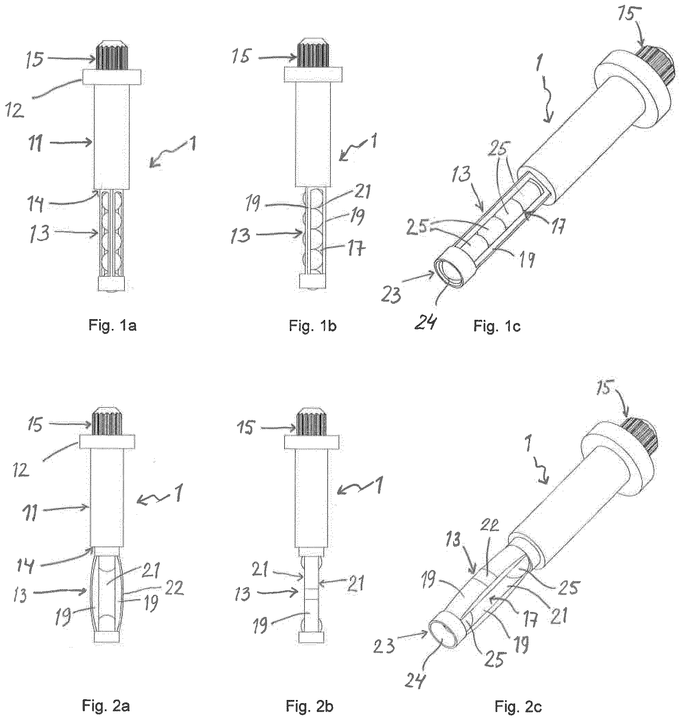

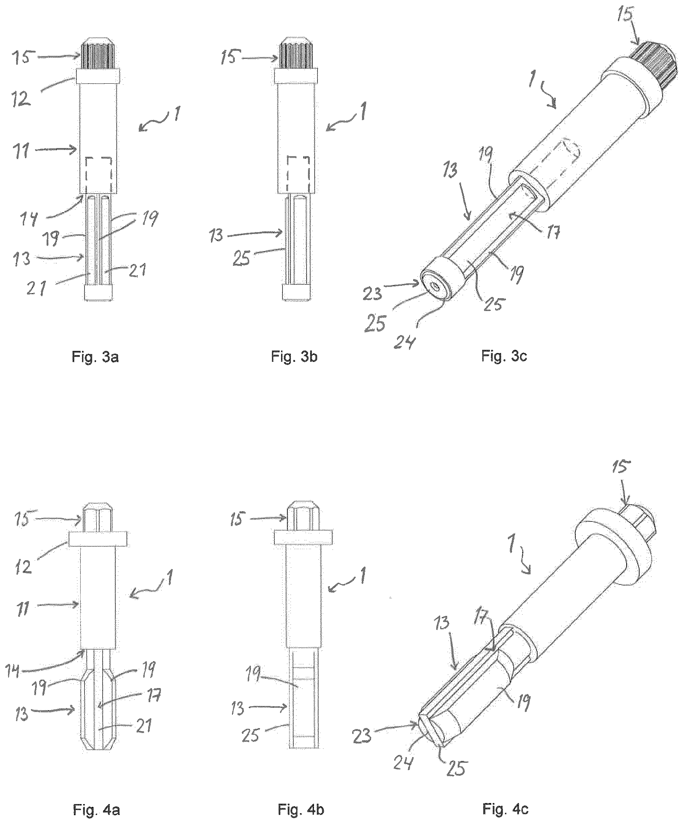

Figs. 1a to 1c illustrate a first embodiment of a connection pin 1 according to the present disclosure. The connection pin is made of an electrically and thermally conductive material, e.g. a metal such as copper or brass alloy, and has a general cylindrical shape. The connection pin has a first contact part 13 that is adapted for mounting in a hole in a first PCB. The connection pin has a second contact part 15 that is adapted for mounting in another element, e.g. another, second, PCB. The first contact part 13 comprises an internal cavity 17 surrounded by a wall 19. The wall is provided with at least one wall opening 21, which in the first embodiment is three rectangular openings. The connection pin 1 further has an open end 23 located at the end of the connection pin that is closest to the first contact part 13, and an opening 24 provided by the open end 23 communicates with the cavity 17. Inside the cavity, there is arranged one or several solder preforms 25, which in the illustrated embodiment are configured as balls of solder. The balls of solder are insertable into the cavity via the open end 23. The solder balls are retained in the cavity e.g. by means of friction against the wall 19. The length of the openings 21 in the cavity wall 19, in the longitudinal direction of the connection pin, is preferably chosen to correspond to the length of the hole in the PCB for which the connection pin is intended to be used. The cavity has a corresponding length, but there is nothing to prevent that the cavity would extend further into the connection pin. Thus the cavity can contain more solder, if required. This is illustrated by broken lines in Figs. 3a-3c.

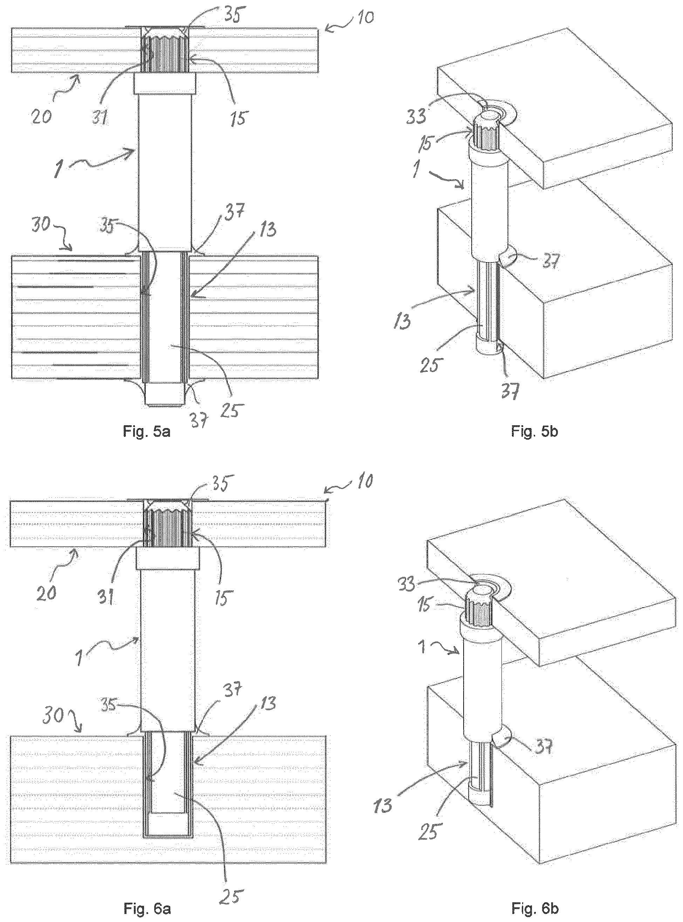

The connection pin further comprises an intermediate part 11, primarily having the function of spacing apart one PCB 30 in which the first contact part 13 is mounted, and another PCB 20 in which the second contact part 15 is mounted, as illustrated in Figs. 5a and 6a. The connection pin also has a flange part 12, which in the illustrated embodiment is located between the intermediate part 11 and the second contact part 15. The flange keeps an element, e.g. a PCB, mounted on the second contact part 15 firmly in place and prevents that it can slide down along the connection pin. The first contact part 13 has an outer diameter that is smaller than the outer diameter of the intermediate part 11 and consequently a shoulder 14 is formed against which the PCB 30 would abut when the connection pin is mounted in the hole of the PCB. It is conceivable that the shoulder and the flange may change places with each other.

The outer diameter of the first contact part 13 is configured to be only slightly smaller than an inner diameter of the corresponding hole in the PCB into which the connection pin is intended to be inserted, such that the connection pin can be slip fitted into said hole.

Figs. 2a to 2c illustrate a second embodiment of a connection pin 1. The following elements of this connection pin 1 are identical to the corresponding elements already described in connection with the first embodiment, and have the same or corresponding functions: a second contact part 15, and open end 23 with an end opening 24, an intermediate part 11, a flange 12, a shoulder 14. The connection pin according to the second embodiment further has a first contact part 13 comprising a cavity 17 surrounded by a wall 19. The wall has openings 21, which in the illustrated embodiment are two openings. There are solder preforms 25 located inside the cavity, and the cavity and the openings have lengths as already described above. Also in this embodiment, the solder preforms 25 are balls of solder, but there is nothing to prevent that the solder preform could have other configurations, e.g. a rod or a plate as shown in Figs. 3c and 4c. In this second embodiment, the wall 19 of the first contact part 13 is configured as at least partly resilient. The wall comprises an inner wall surface that is a plane surface and which supports the solder preform(s) by means of friction. The wall further comprises an outer wall surface that is a curved surface, and comprising at least a part 22 that is designed to abut against the internal surface of the hole in the PCB into which it is intended to be inserted. The wall is mounted between two ends of the first contact part. The wall is thinner at the ends where it is secured to the respective ends of the first contact part, which results in an outwardly bulging wall. The maximum diameter of the outwardly bulging outer wall is somewhat larger than the inner diameter of the hole in the PCB into which it is intended to be inserted, and consequently the first contact part of the connection pin is press fitted into said hole in the PCB. The wall can also be made of a material having some resiliency, or a compressible material, and then it will have a spring quality that will make it possible to mount the first contact part in a hole of a PCB without press fit. Alternatively, the wall may have a constant thickness such that it is preloaded similar to a spring and thereby bulges outwards. It can then be described as similar to a crocodile clip.

Figs. 3a to 3c illustrate a third embodiment of a connection pin 1. All of the elements of this embodiment are identical to the first embodiment, with the exception of the solder preform 25 being a solder rod instead of balls of solder. The flange 12 is also illustrated as having a slightly smaller diameter, which of course is possible to have also in the other embodiments, without departing from the inventive concept. In these figures is also illustrated the general option of prolonging the length of the cavity into the intermediate part of the connection pin, which is applicable to all embodiments.

Figs. 4a to 4c illustrate a fourth embodiment of a connection pin 1. The following elements of this connection pin 1 are identical to the corresponding elements already described in connection with the first embodiment, and have the same or corresponding functions: a second contact part 15, and open end 23 with an end opening 24, an intermediate part 11, a flange 12, a shoulder 14. The connection pin according to the fourth embodiment further has a first contact part 13 comprising a cavity 17 surrounded by a wall 19. In this embodiment, the solder preform 25 has the shape of a rectangular solder plate and the cavity 17 has a corresponding rectangular form. The wall 19 has two openings 21 on opposing sides and the maximum outer diameter of the wall is slightly smaller than an inner diameter of the corresponding hole in the PCB into which the connection pin is intended to be inserted, such that the connection pin can be slip fitted into said hole. The cavity 17 and the wall openings 21 have lengths as already described above.

In Figs. 5a to 5b and 6a to 6b are schematically illustrated a first and a second embodiment of a converter assembly, e.g. a dc/dc converter, comprising a substrate 10 with a PCB 20 and a connection pin 1 mounted in the PCB, by means of the second contact part 15 of the connection pin being inserted into a hole 31 in the PCB. This PCB will in the following be referred to as the first PCB. The substrate hole 31 has an electrically conductive inner wall, which can be obtained by e.g. electroplating of an electrically conductive material, as illustrated in Figs. 5a-b and 6a-b. The shown connection pin 1 corresponds to the connection pin illustrated in Fig. 3, having a solder preform 25 in the shape of a solder rod. However, a connection pin according to any one of the described embodiments may be used, or similar pins. The second contact part 15 is configured with a number of peripheral ribs in order to be secured in the substrate hole by press fitting. These ribs can have different shapes as for example seen in Figs. 1a and 4a. Alternatively, other means for securing the connection pin to the substrate can also be foreseen as will be realized by a skilled person. The connection pin can be soldered to the substrate at this stage, by performing a soldering step, or this can be made later together with the soldering to the second PCB, when the first contact part has been connected thereto. E.g. a layer of solder paste 33 may have been deposited around the upper opening of the hole, on the substrate, by for example screen printing or another known method. During the soldering process, the solder will adhere to the surfaces of the hole and the pin by wetting and flow down inbetween the ribs, fill all empty spaces and secure mechanical and/or conductive connection between the connection pin, the surface of the substrate and internal conductive layers of the substrate. The substrate comprising the PCB and with the connection pin mounted thereto may be considered as such as a market product.

In the illustrated embodiment, the first contact part 13 is mounted in a hole 35 in a second PCB 30. This hole can be e.g. a through hole as shown in Fig. 5a-b, or a blind via as shown in Fig. 6a-b. Also in this case the hole has an electrically conductive inner wall, which can be obtained by e.g. electroplating. After the first contact part 13 has been mounted in the PCB hole 35, the soldering process can be started, e.g. a solder reflow process. The solder will adhere to the surfaces of the connection pin and the hole 35 by wetting and melt to fill all, or close to all, of the empty spaces in the hole 35. It can also flow to make solder fillets 37 around the openings of the hole 35. As a result, the melted solder will secure conductive connection between the connection pin, the upper and lower surfaces of the second PCB around the hole 35 and internal conductive layers of the second PCB. The conductive connection is not only an electrically conductive connection, but also thermal conduction is obtained. In addition, mechanical connection is also obtained.

In the illustrated embodiments of Figs. 5a-5b and 6a-6b, the contact parts are electric contact parts and the holes in the PCB:s are conductive holes, but they can as well be holes for simply providing a mechanical connection by means of the connection pin, such as when a connection pin functions as a guide pin in an SMT application. It is also conceivable that the connection pin is oppositely oriented, such that the first contact part of the connection pin with the solder cavity is inserted in a hole in a converter substrate PCB.

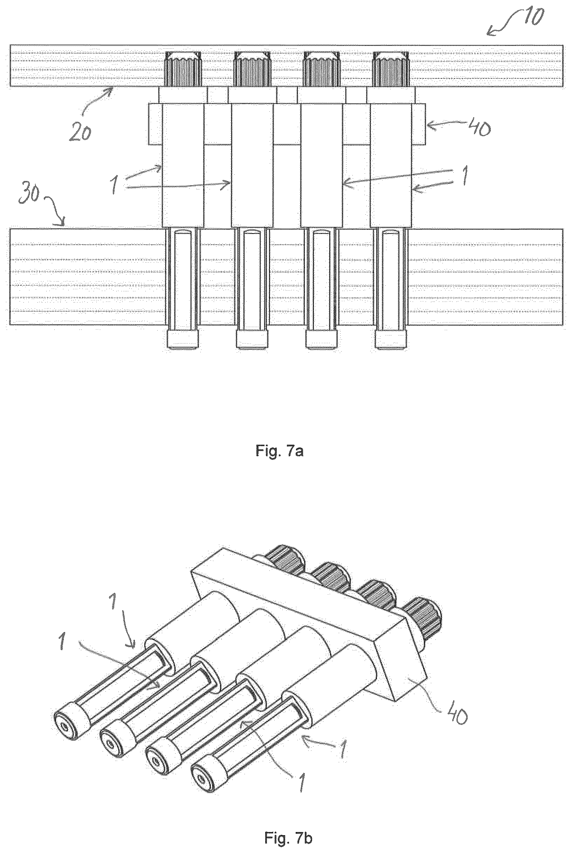

Further, in the embodiments of Figs. 5a-b and 6a-b, only one connection pin has been illustrated, but naturally in the most common case there will be a number of holes in the first PCB and in the second PCB and also a number of connection pins mounted thereto. In Figs 7a and 7b is illustrated an embodiment with a header 40 in which four connection pins 1 are held together. The header is a piece of insulating material provided with holes in which the connection pins are supported, and it can of course be adapted for any number of connection pins. The arrangement with a header 40 will facilitate the handling and the mounting of the connection pins. In Fig. 7a is illustrated how the connection pins, as held together by means of the header, are mounted by their first contact part in corresponding holes in a PCB 30 and by their second contact part 15 in a substrate 10.

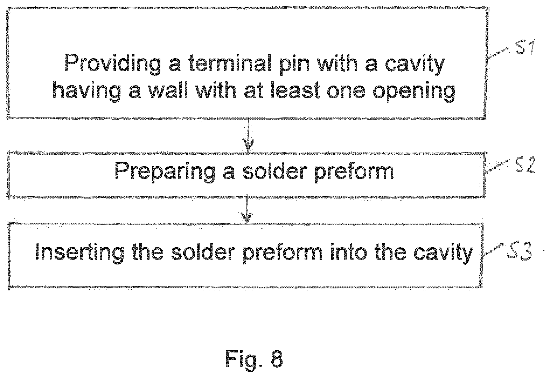

Finally, in Fig. 8 is shown a schematic diagram illustrating the different steps of a method for manufacturing a connection pin 1. These steps comprise:
- S1 providing a connection pin with a cavity in a contact part of the pin, and providing at least one opening in a wall of the cavity,
- S2 preparing at least one solder preform, and
- S3 inserting at least one solder preform into said cavity.

A further step S4 comprises inserting the at least one solder preform into the cavity via an open end of the connection pin, which open end communicates with the cavity.

An additional step S5 also comprises preparing a solder preform by cutting solder wire in lengths adapted to the length of the cavity, pressing several solder wire lengths together thereby forming a solder preform.

The invention shall not be considered limited to the illustrated embodiments, but can be modified and altered in many ways, as realised by a person skilled in the art, without departing from the scope defined in the appended claims.

## Claims

1. A connection pin (1) comprising a first contact part (13) that is adapted for mounting in a hole in a printed circuit board (PCB) by soldering to an inner wall of the hole in the printed circuit board, and a second contact part (15), wherein the first contact part comprises a cavity (17) surrounded by a wall (19), wherein the wall has at least one opening (21), and wherein at least one solder preform (25) is located in the cavity (17), **characterized in that** the connection pin (1) has an open end (23) located at the end of the connection pin that is closest to the first contact part (13), and that an opening (24) provided by the open end (23) communicates with the cavity (17).

2. The connection pin according to claim 1, wherein the first contact part (13) has an outer diameter that is adapted for a slip fit into a hole of a PCB, wherein the outer diameter of the first contact part (13) is configured to be only slightly smaller than an inner diameter of the corresponding hole.

3. The connection pin according to claim 1, wherein at least a part of the wall (19) of the cavity (17) is resilient, and wherein this part of the wall has an outer diameter that is larger than a diameter of a hole in a PCB in which the connection pin is intended to be mounted.

4. The connection pin according to claim 1, wherein the first contact part (13) has an outer diameter that is adapted for a press-fit into a hole of a PCB, wherein the wall (19) of the first contact part (13) is configured as at least partly resilient and having a curved outer wall surface comprising at least a part (22) that is designed to abut against the internal surface of the hole in the PCB and resulting in an outwardly bulging outer wall of the first contact part (13), and wherein a maximum diameter of the outwardly bulging outer wall is somewhat larger than the inner diameter of the hole in the PCB into which it is intended to be inserted.

5. The connection pin according to any one of the preceding claims, wherein the cavity (17) has a length corresponding to at least the length of the hole, and the at least one opening (21) in the wall (19) has a length corresponding to the length of the hole.

6. The connection pin according to claim 5, wherein it comprises an intermediate part (11) between the first contact part and the second contact part.

7. The connection pin according to claim 6, wherein it comprises a flange part (12) between the intermediate part (11) and the second contact part (15).

8. A converter assembly comprising:
- a first printed circuit board, PCB, (20), said first PCB (20) having at least one hole (31) configured to receive a connection pin (1),
- at least one connection pin (1) according to any one of claims 1-7, of which either one of the first contact part (13) and the second contact part (15) is mounted in said hole (31) in the first PCB.

9. The converter assembly according to claim 8, further comprising a second printed circuit board, PCB, (30) having at least one hole (35), wherein the other contact part (13) of the connection pin (1) that is not mounted in the first PCB is mounted in said hole of the second PCB.

10. The converter assembly according to claim 8 or claim 9, wherein the first contact part is soldered to an inner wall of the hole in the PCB in which it is mounted, by means of melting the solder preform (25).

11. The converter assembly according to claim 10, wherein the first contact part (13) is soldered to the inner wall of the hole (35) in the PCB in which it is mounted, with a reflow process.

12. The converter assembly according to any one of claims 8-11, wherein it comprises several connection pins (1) mounted in a header (40), wherein the first PCB (20) comprises at least as many holes (31) as the number of connection pins mounted in the header, and wherein the first contact part or the second contact part (15) of the respective connection pin is mounted in a respective hole (35) configured therefor in the first PCB (20).

13. A method for manufacturing a connection pin comprising a first contact part (13) that is adapted for mounting in a hole in a printed circuit board (PCB) by soldering to an inner wall of the hole in the printed circuit board, and a second contact part (15), the method comprising:
- providing a connection pin with a cavity in the first contact part of the connection pin, and providing at least one opening in a wall of the cavity (S1),
- preparing at least one solder preform (S2), and
- inserting at least one solder preform into said cavity (S3),
**characterized by** inserting said at least one solder preform into the cavity via an open end (23) of the connection pin, which open end (23) is located at the end of the connection pin that is closest to the first contact part (13), and has an opening (24) that communicates with the cavity (S4).

14. A method according to claim 13, comprising preparing a solder preform by cutting solder wire in lengths adapted to the length of the cavity, and pressing several solder wire lengths together thereby forming a solder preform (S5).

## Patentansprüche

1. Anschlussstift (1), umfassend einen ersten Kontaktteil (13), der zum Montieren in einem Loch in einer Leiterplatte (PCB) durch Löten an eine Innenwand des Lochs in der Leiterplatte angepasst ist, und einem zweiten Kontaktteil (15), wobei der erste Kontaktteil einen Hohlraum (17) umfasst, der von einer Wand (19) umgeben ist, wobei die Wand mindestens eine Öffnung (21) aufweist und wobei mindestens eine Lötvorform (25) im Hohlraum (17) verortet ist, **dadurch gekennzeichnet, dass** der Anschlussstift (1) ein offenes Ende (23) aufweist, das am Ende des Anschlussstifts verortet ist, das dem ersten Kontaktteil (13) am nächsten liegt, und dass eine Öffnung (24), die von dem offenen Ende (23) bereitgestellt ist, mit dem Hohlraum (17) in Verbindung steht.

2. Anschlussstift nach Anspruch 1, wobei der erste Kontaktteil (13) einen Außendurchmesser aufweist, der für einen Schlupfsitz in ein Loch eines PCBs angepasst ist, wobei der Außendurchmesser des ersten Kontaktteils (13) dafür eingerichtet ist, nur geringfügig kleiner zu sein als ein Innendurchmesser des entsprechenden Lochs.

3. Anschlussstift nach Anspruch 1, wobei mindestens ein Teil der Wand (19) des Hohlraums (17) elastisch ist und wobei dieser Teil der Wand einen Außendurchmesser aufweist, der größer ist als ein Durchmesser eines Lochs in einem PCB, in dem der Anschlussstift vorgesehen ist, montiert zu werden.

4. Anschlussstift nach Anspruch 1, wobei der erste Kontaktteil (13) einen Außendurchmesser aufweist, der für einen Presssitz in ein Loch eines PCBs angepasst ist, wobei die Wand (19) des ersten Kontaktteils (13) als mindestens teilweise elastisch eingerichtet ist und eine gekrümmte Außenwandoberfläche aufweist, die mindestens einen Teil (22) umfasst, der so gestaltet ist, dass er gegen die Innenoberfläche des Lochs in dem PCB anstößt und in einer sich nach außen wölbenden Außenwand des ersten Kontaktteils (13) resultiert, und wobei ein maximaler Durchmesser der sich nach außen wölbenden Außenwand etwas größer ist als der Innendurchmesser des Lochs in dem PCB, in das sie vorgesehen ist, eingesetzt zu werden.

5. Anschlussstift nach einem der vorstehenden Ansprüche, wobei der Hohlraum (17) eine Länge aufweist, die mindestens der Länge des Lochs entspricht, und die mindestens eine Öffnung (21) in der Wand (19) eine Länge aufweist, die der Länge des Lochs entspricht.

6. Anschlussstift nach Anspruch 5, wobei er ein Zwischenteil (11) zwischen dem ersten Kontaktteil und dem zweiten Kontaktteil umfasst.

7. Anschlussstift nach Anspruch 6, wobei er ein Flanschteil (12) zwischen dem Zwischenteil (11) und dem zweiten Kontaktteil (15) umfasst.

8. Wandleranordnung, umfassend:
- eine erste Leiterplatte, PCB, (20), wobei das erste PCB (20) mindestens ein Loch (31) aufweist, das dafür eingerichtet ist, einen Anschlussstift (1) zu empfangen,
- mindestens einen Anschlussstift (1) nach einem der Ansprüche 1 - 7, von denen einer des ersten Kontaktteils (13) und des zweite Kontaktteils (15) in dem Loch (31) in dem ersten PCB montiert ist.

9. Wandleranordnung nach Anspruch 8, weiter umfassend eine zweite Leiterplatte, PCB, (30), die mindestens ein Loch (35) aufweist, wobei der andere Kontaktteil (13) des Anschlussstifts (1), der nicht in dem ersten PCB montiert ist, in dem Loch des zweiten PCBs montiert ist.

10. Wandleranordnung nach Anspruch 8 oder Anspruch 9, wobei der erste Kontaktteil mittels Schmelzen der Lötvorform (25) an eine Innenwand des Lochs in dem PCB, in dem er montiert ist, gelötet ist.

11. Wandleranordnung nach Anspruch 10, wobei der erste Kontaktteil (13) an die Innenwand des Lochs (35) in dem PCB, in dem er montiert ist, mit einem Reflowprozess gelötet ist.

12. Wandleranordnung nach einem der Ansprüche 8 - 11, wobei sie mehrere Anschlussstifte (1) umfasst, die in einer Stiftleiste (40) montiert sind, wobei das erste PCB (20) mindestens so viele Löcher (31) umfasst wie die Anzahl der in der Stiftleiste montierten Anschlussstifte und wobei der erste Kontaktteil oder der zweite Kontaktteil (15) des jeweiligen Anschlussstifts in einem jeweiligen Loch (35) montiert ist, das dafür in dem ersten PCB (20) eingerichtet ist.

13. Verfahren zum Herstellen eines Anschlussstifts, umfassend einen ersten Kontaktteil (13), der zum Montieren in einem Loch in einer Leiterplatte (PCB) durch Löten an eine Innenwand des Lochs in der Leiterplatte angepasst ist, und einen zweiten Kontaktteil (15), das Verfahren umfassend:
- Bereitstellen eines Anschlussstifts mit einem Hohlraum im ersten Kontaktteil des Anschlussstifts und
Bereitstellen mindestens einer Öffnung in einer Wand des Hohlraums (S1),
- Vorbereiten mindestens einer Lötvorform (S2) und
- Einsetzen mindestens einer Lötvorform in den Hohlraum (S3),
**gekennzeichnet durch** Einsetzen der mindestens einen Lötvorform in den Hohlraum über ein offenes Ende (23) des Anschlussstifts, wobei das offene Ende (23) am Ende des Anschlussstifts verortet ist, das dem ersten Kontaktteil (13) am nächsten liegt und eine Öffnung (24) aufweist, die mit dem Hohlraum in Verbindung steht (S4).

14. Verfahren nach Anspruch 13, umfassend Vorbereiten einer Lötvorform durch Schneiden von Lötdraht in Längen, die der Länge des Hohlraums angepasst sind, und Zusammenpressen mehrerer Lötdrahtlängen, was eine Lötvorform bildet (S5).

## Revendications

1. Broche de connexion (1) comprenant une première partie de contact (13) qui est adaptée pour montage dans un trou dans une carte de circuit imprimé (PCB) par soudage à une paroi intérieure du trou dans la carte de circuit imprimé, et une seconde partie de contact (15), dans laquelle la première partie de contact comprend une cavité (17) entourée par une paroi (19), dans lequel la paroi a au moins une ouverture (21), et dans laquelle au moins une préforme de soudure (25) est située dans la cavité (17), **caractérisée en ce que** la broche de connexion (1) a une extrémité ouverte (23) située au niveau de l'extrémité de la broche de connexion qui est la plus proche de la première partie de contact (13), et **en ce qu'**une ouverture (24) fournie par l'extrémité ouverte (23) communique avec la cavité (17).

2. Broche de connexion selon la revendication 1, dans laquelle la première partie de contact (13) a un diamètre extérieur qui est conçu pour un glissement emboîté dans un trou d'un PCB, dans laquelle le diamètre extérieur de la première partie de contact (13) est configuré pour être seulement légèrement plus petit qu'un diamètre intérieur du trou correspondant.

3. Broche de connexion selon la revendication 1, dans laquelle au moins une partie de la paroi (19) de la cavité (17) est élastique et dans laquelle cette partie de la paroi a un diamètre extérieur qui est plus grand qu'un diamètre d'un trou dans une PCB dans laquelle la broche de connexion est destinée à être montée.

4. Broche de connexion selon la revendication 1, dans laquelle la première partie de contact (13) a un diamètre extérieur qui est conçu pour un ajustement par pression dans un trou d'une PCB, dans laquelle la paroi (19) de la première partie de contact (13) est configurée comme étant au moins partiellement élastique et ayant une surface de paroi extérieure incurvée comprenant au moins une partie (22) qui est conçue pour buter contre la surface interne du trou dans la PCB et aboutissant à une paroi extérieure bombant vers l'extérieur de la première partie de contact (13), et dans laquelle un diamètre maximal de la paroi extérieure bombant vers l'extérieur est quelque peu plus grand que le diamètre intérieur du trou dans la PCB dans lequel elle est destinée à être insérée.

5. Broche de connexion selon l'une quelconque des revendications précédentes, dans laquelle la cavité (17) a une longueur correspondant à au moins la longueur du trou, et l'au moins une ouverture (21) dans la paroi (19) a une longueur correspondant à la longueur du trou.

6. Broche de connexion selon la revendication 5, dans laquelle elle comprend une partie intermédiaire (11) entre la première partie de contact et la seconde partie de contact.

7. Broche de connexion selon la revendication 6, dans laquelle elle comprend une partie bride (12) entre la partie intermédiaire (11) et la seconde partie de contact (15).

8. Ensemble convertisseur comprenant :
- une première carte de circuit imprimé, PCB, (20), ladite première PCB (20) ayant au moins un trou (31) configuré pour recevoir une broche de connexion (1),
- au moins une broche de connexion (1) selon l'une quelconque des revendications 1 à 7, dont l'une ou l'autre de la première partie de contact (13) et de la seconde partie de contact (15) est montée dans ledit trou (31) dans la première PCB.

9. Ensemble convertisseur selon la revendication 8, comprenant en outre une seconde carte de circuit imprimé, PCB, (30) ayant au moins un trou (35), dans lequel l'autre partie de contact (13) de la broche de connexion (1) qui n'est pas montée dans la première PCB est montée dans ledit trou de la seconde PCB.

10. Ensemble convertisseur selon la revendication 8 ou la revendication 9, dans lequel la première partie de contact est soudée à une paroi intérieure du trou dans la PCB dans lequel elle est montée, au moyen de la fonte de la préforme de soudure (25).

11. Ensemble convertisseur selon la revendication 10, dans lequel la première partie de contact (13) est soudée à la paroi intérieure du trou (35) dans la PCB dans lequel elle est montée, par un processus de refusion.

12. Ensemble convertisseur selon l'une quelconque des revendications 8 à 11, dans lequel il comprend plusieurs broches de connexion (1) montées dans un en-tête (40), dans lequel la première PCB (20) comprend au moins autant de trous (31) que le nombre de broches de connexion montées dans l'en-tête, et dans lequel la première partie de contact ou la seconde partie de contact (15) de la broche de connexion respective est montée dans un trou respectif (35) configuré pour celle-ci dans la première PCB (20).

13. Procédé pour fabriquer une broche de connexion comprenant une première partie de contact (13) qui est adaptée pour montage dans un trou dans une carte de circuit imprimé (PCB) par soudage à une paroi intérieure du trou dans la carte de circuit imprimé, et une seconde partie de contact (15), le procédé comprenant :
- la fourniture d'une broche de connexion avec une cavité dans la première partie de contact de la broche de connexion, et la fourniture d'au moins une ouverture dans une paroi de la cavité (S1),
- la préparation d'au moins une préforme de soudure (S2), et
- l'insertion d'au moins une préforme de soudure dans ladite cavité (S3),
**caractérisé par** l'insertion de ladite au moins une préforme de soudure dans la cavité via une extrémité ouverte (23) de la broche de connexion, laquelle extrémité ouverte (23) est située au niveau de l'extrémité de la broche de connexion qui est la plus proche de la première partie de contact (13), et a une ouverture (24) qui communique avec la cavité (S4).

14. Procédé selon la revendication 13, comprenant la préparation d'une préforme de soudure en coupant du fil de soudure à des longueurs adaptées à la longueur de la cavité, et le pressage de plusieurs longueurs de fil de soudure ensemble formant de ce fait une préforme de soudure (S5).
